(19) Europäisches Patentamt
European Patent Office
Office européen des brevets

(11) **EP 2 461 169 A2**

(12) **EUROPÄISCHE PATENTANMELDUNG**

(43) Veröffentlichungstag:
**06.06.2012 Patentblatt 2012/23**

(51) Int Cl.:
***G01R 23/00*** *(2006.01)*

(21) Anmeldenummer: **11182362.1**

(22) Anmeldetag: **22.09.2011**

| | |
|---|---|
| (84) Benannte Vertragsstaaten:<br>**AL AT BE BG CH CY CZ DE DK EE ES FI FR GB GR HR HU IE IS IT LI LT LU LV MC MK MT NL NO PL PT RO RS SE SI SK SM TR**<br>Benannte Erstreckungsstaaten:<br>**BA ME** | (72) Erfinder:<br>• **Freking, Benno**<br>  **28844 Weyhe-Leeste (DE)**<br>• **Biegler, Heiko**<br>  **28309 Bremen (DE)** |
| (30) Priorität: **09.10.2010 DE 102010048091** | (74) Vertreter: **Wasiljeff, Johannes M.B.**<br>**Jabbusch Siekmann & Wasiljeff**<br>**Patentanwälte**<br>**Otto-Lilienthal-Strasse 25**<br>**28199 Bremen (DE)** |
| (71) Anmelder: **ATLAS Elektronik GmbH**<br>**28309 Bremen (DE)** | |

(54) **Verfahren und Vorrichtung zur Ermittlung einer Frequenz eines Signals**

(57) Die Erfindung betrifft ein Verfahren sowie eine Vorrichtung zum Ermitteln wenigstens einer Frequenz $f_0$ eines Signals $s[n]$. Gemäß dieser Erfindung wird das Signal $s[n]$ mittels eines mindestens zwei frequenzabhängigen Filter $H_j(z)$, $H_k(z)$ umfassenden Filtermoduls 40 gefiltert und aus dadurch erzeugten gefilterten Signalen $s_j[n]$, $s_k[n]$ mittels eines Gleichungsmoduls 42 durch Ermitteln eines Quotienten, nämlich einen aus nur einem oder mehreren Werten bestehenden Amplitudenquotienten $\Theta[n]$, aus den gefilterten Signalen $s_j[n]$, $s_k[n]$. Es

wird die wenigstens eine Frequenz $f_0$ ermittelt, bei der wenigstens ein Amplitudenwert eines relativen Frequenzgangs $H_\Theta(\omega)$, der ein Quotient von den zwei Amplitudenfrequenzgängen $H_j(\omega)$, $H_k(\omega)$ der zwei frequenzabhängigen Filter $H_j(z)$, $H_k(z)$ ist, dem einen oder mehreren Werten umfassenden Amplitudenquotient $\Theta[n]$ entspricht.

Ferner betrifft die Erfindung ein Computerprogramm, welches zum Durchführen des erfindungsgemäßen Verfahrens über geeignete Programmcodemittel verfügt.

Fig. 3

**EP 2 461 169 A2**

**Beschreibung**

Die Erfindung betrifft ein Verfahren zum Ermitteln einer Frequenz eines Signals gemäß Anspruch 1, eine Vorrichtung zum Durchführen des derartigen Verfahrens gemäß Anspruch 12 sowie ein Computerprogramm gemäß Anspruch 15, welches zum Ausführen des Verfahrens über geeignete Programmcodemittel verfügt.

Herkömmlicherweise werden durch Sonarverfahren, Radarverfahren oder weiteren den Dopplereffekt zu Nutze machende Verfahren wenigstens eine Frequenz eines reflektierten Signals zur relativen Geschwindigkeitsmessung ermittelt. Ferner wird bei drahtlosen Übertragungsverfahren eine einzelne Frequenz eines Signals, nämlich eines sog. Pilottons, zur Kontrolle, Steuerung, Referenz und Überwachung ermittelt. Ferner werden wenigstens eine Frequenz ermittelnde Verfahren mittels Computerprogrammen und/oder Softwaremodulen wie bspw. MATLAB bereitgestellt und ggf. ausgeführt.

DE 35 048 90 A1 beschreibt ein Verfahren zur diskreten Frequenzmessung eines eine Frequenz aufweisenden Signals durch Zählen einer Anzahl von Nulldurchgängen des Signals. Hierfür wird eine abgeleitete Funktion und eine integrale Funktion des Signals erzeugt, mittels denen die Nulldurchgänge während eines vorbestimmten Zeitintervalls gezählt werden. Anhand der gezählten Nulldurchgänge wird die Frequenz des Signals ermittelt.

Dieses bekannte Verfahren hat den Nachteil, dass ein vorbestimmtes Zeitintervall eingehalten werden muss. Ferner ist die Genauigkeit der zu ermittelnden Frequenz von einer Zeitdiskretisierung des Signals abhängig.

DE 196 08 331 C2 beschreibt eine Vorrichtung zum Messen einer Frequenz eines diskreten Signals sowie eine Verwendung dieser Vorrichtung zur Messung einer Geschwindigkeit von Wasserfahrzeugen. Diese bekannte Vorrichtung weist ein Schieberegister auf, das derart ausgebildet ist, um aus dem Signal ein geklipptes Signal zu erzeugen und als Einheitsimpulse einzulesen. Ferner weist es Mittel auf, die derart ausgebildet sind, um eine Häufigkeit einer Belegung der eingelesenen Einheitsimpulse an jeder Bitstelle im Schieberegister zu ermitteln und um aus dieser Häufigkeit die Frequenz des diskreten Signals zu ermitteln.

Dieses bekannte Verfahren hat den Nachteil, dass eine Messgenauigkeit der Frequenzermittlung durch die Anzahl der aus den Signal verstärkten und dadurch geklippten Einheitsimpulsen und ihrer Häufigkeit an einer der vorbestimmten Frequenz entsprechenden Bitstelle abhängt. Die Messgenauigkeit der Frequenz hängt somit sowohl von einer Zeitdiskretisierung als auch von einer Anzahl der zeitdiskreten Werte des Signals zur Häufigkeitsbestimmung ab.

WO2004/005945 A1 zeigt ein Verfahren zur Frequenzschätzung. Dieses bekannte Verfahren führt zunächst eine schnelle Fourier-Transformation, nachfolgend als FFT bezeichnet, aus und ermittelt nur einen Koeffizienten der FFT, nämlich den Koeffizienten dessen Betrag maximal ist. Auf diese Weise entspricht die zu ermittelnde Frequenz die diesem Koeffizienten entsprechende Frequenz. Ferner wird die Messgenauigkeit mit einer modifizierten diskreten Fourier-Transformation, nachfolgend als DFT bezeichnet, erhöht, indem Koeffizienten der DFT verändert werden.

Dieses bekannte Verfahren hat den Nachteil, das die FFT und anschließende DFT eine vorbestimmte Anzahl an zeitdiskreten Werten benötigt und dieses bekannte Verfahren mehrere Iterationen durchführen muss, um die Messgenauigkeit zu erhöhen.

Der Erfindung liegt nach alledem das Problem zugrunde, mittels eines kürzeren Zeitabschnitts des Signals oder einer geringeren Anzahl an zeitdiskreten Werten des Signals wenigstens eine Frequenz des Signals mit wesentlich höherer Messgenauigkeit, d.h. Frequenzauflösung, zu ermitteln.

Die Erfindung löst dieses Problem der eingangs genannten Art durch ein Verfahren, eine Vorrichtung und ein Computerprogramm. Das erfindungsgemäße Verfahren filtert das Signal mittels eines ersten frequenzabhängigen Filters zum Erzeugen von einem ersten gefilterten Signal und filtert dasselbe Signal mittels eines vom ersten frequenzabhängigen Filter verschiedenen zweiten frequenzabhängigen Filters zum Erzeugen von einem zweiten gefilterten Signal. Ferner wird gemäß dem erfindungsgemäßen Verfahren wenigstens ein Quotient, nämlich ein aus nur einem oder mehreren Werten bestehender Amplitudenquotient, vom ersten gefilterten Signal zum zweiten gefilterten Signal ermittelt. Mittels dieses einem oder mehrere Werte umfassenden Amplitudenquotienten und einem relativen Frequenzgang, der ein Quotient von einem Amplitudenfrequenzgang des ersten frequenzabhängigen Filters zu einem Amplitudenfrequenzgang des zweiten frequenzabhängigen Filters ist, wird die wenigstens eine Frequenz ermittelt, bei der wenigstens ein Amplitudenwert des relativen Frequenzgangs dem einen oder mehrere Werte umfassenden Amplitudenquotienten entspricht.

Ferner löst die Erfindung das Problem mittels einer Vorrichtung, die ein Filtermodul, ein Relationsmodul und ein Gleichungsmodul aufweist. Das Filtermodul umfasst mindestens einen ersten frequenzabhängigen Filter sowie einen vom ersten frequenzabhängigen Filter verschiedenen zweiten frequenzabhängigen Filter, die derart ausgebildet sind, um das Signal zu filtern, damit ein erstes gefiltertes Signal und ein zweites gefiltertes Signal erzeugbar sind.

Ferner weist die erfindungsgemäße Vorrichtung ein Relationsmodul auf, das derart ausgebildet ist, um wenigstens einen Quotienten, nämlich einen aus nur einem oder mehreren Werten bestehenden Amplitudenquotienten, vom ersten gefilterten Signal zum zweiten gefilterten Signal zu ermitteln.

Schließlich weist die erfindungsgemäße Vorrichtung ein Gleichungsmodul auf, das derart ausgebildet ist, um die wenigstens eine Frequenz zu ermitteln, bei der ein Amplitudenwert eines relativen Frequenzgangs, der ein Quotient von einem Amplitudenfrequenzgang des ersten frequenzabhängigen Filters zu einem Amplitudenfrequenzgang des zweiten frequenzabhängigen Filters ist, dem einen oder mehrere Werte umfassenden Amplitudenquotienten entspricht.

Der Erfindung liegt die Erkenntnis zugrunde, dass das Ermitteln der wenigstens einen Frequenz des Signals nicht notwendigerweise mittels eines einer FFT verwendendes Verfahren und/oder von einer vorbestimmten Dauer des Signals oder von einer vorbestimmten Anzahl von zeitdiskreten Werten des Signals abhängen muss, sondern dass das Ermitteln der Frequenz des Signals durch Filtern des Signals mittels des mindestens zwei voneinander verschieden frequenzabhängigen Filtern umfassendes Filtermoduls und Weiterverarbeitung der durch das Filtern des Signals erzeugten gefilterten Signale möglich ist.

Das Weiterverarbeiten der gefilterten Signale umfasst mittels des Relationsmoduls das Bilden eines Verhältnisses der zwei gefilterten Signale zueinander zum Erzeugen eines aus nur einem oder mehreren Werten bestehenden Amplitudenquotienten. Vorteilhafterweise kann zum Ermitteln eines aus nur einem oder mehreren Werten bestehenden Amplitudenquotienten zu einem beliebigen Zeitpunkt das Verhältnis der zwei gefilterten Signale zueinander gebildet werden. Hierdurch kann der Amplitudenquotient für einen Zeitpunkt oder für mehrere Zeitpunkte des Signals ermittelt werden. Auf diese Weise ist der Quotient unabhängig von einer vorbestimmten Anzahl von Werten, einer vorbestimmten Anzahl an periodischen Schwingungen oder von einem zeitlichen Messintervall des Signals.

Die Weiterverarbeitung der gefilterten Signale umfasst ferner das Ermitteln der wenigstens einen Frequenz aus diesen bzw. diesem Amplitudenquotienten sowie aus dem relativen Frequenzgang mittels des Gleichungsmoduls. Falls der Amplitudenquotient vom ersten gefilterten Signal zum zweiten gefilterten Signal ermittelt wurde, folgt bzgl. des relativen Frequenzgangs, dass dieser aus einem Quotienten vom Amplitudenfrequenzgang des ersten frequenzabhängigen Filters zum Amplitudenfrequenzgang des zweiten frequenzabhängigen Filters ermittelt wird. Falls jedoch der Amplitudenquotient vom zweiten gefilterten Signal zum ersten gefilterten Signal ermittelt wurde, folgt bzgl. des relativen Frequenzgangs, dass dieser aus einem Quotienten vom Amplitudenfrequenzgang des zweiten frequenzabhängigen Filters zum Amplitudenfrequenzgang des ersten frequenzabhängigen Filters gebildet wird. Auf diese Weise sind beide Quotienten, nämlich der Amplitudenquotient und der relative Frequenzgang, zueinander analog in Relation gesetzt, um die Frequenz des Signals zu ermitteln.

Das erste gefilterte Signal muss nicht notwendigerweise dem zeitlich zuerst gefilterten Signal entsprechen. Vielmehr ist das erste gefilterte Signal als nur ein Anteil der aus der Auswahl des Filterpaars resultierenden gefilterten Signale zu betrachten. Analog ist das zweite gefilterte Signal ebenfalls nur ein weiterer Anteil, um den Amplitudenquotienten zu bilden.

Vorteilhafterweise entspricht wenigstens ein Amplitudenwert aus dem relativen Frequenzgang dem ein oder mehrere Werte umfassenden Amplitudenquotienten. Der auf diese Weise entsprechende wenigstens eine Amplitudenwert des relativen Frequenzgangs, entspricht somit wenigstens einer Frequenz des relativen Frequenzgangs. Der relative Frequenzgang weist daher Amplitudenwerte auf, die sich auf eine oder mehrere Frequenzen beziehen.

Bevorzugterweise wird ein Amplitudenfrequenzgang aus einer Übertragungsfunktion eines Filters berechnet, indem der Betrag der Übertragungsfunktion gebildet wird. Der Amplitudenfrequenzgang weist daher nur Amplituden über eine Frequenz im Frequenzbereich auf. Im Gegensatz zu dem Amplitudenfrequenzgang weist ein Phasenfrequenzgang nur die Phase der Übertragungsfunktion auf.

Bei einer bevorzugten Ausführungsform wird das erste frequenzabhängige Filter und das zweite frequenzabhängige Filter, nachfolgend als Filterpaar bezeichnet, vor dem Filtern des Signals aus einer Vielzahl von frequenzabhängigen Filtern, insbesondere aus einer mindestens drei Filter aufweisenden Filterbank, ausgewählt, wobei zumindest eines der Filter des Filterpaars im Bereich der wenigstens einen Frequenz eine positive Steigung oder eine negative Steigung in seinem Amplitudenfrequenzgang aufweisen muss. Auf diese Weise wird eine Mehrzahl von Filterpaaren durch Auswählen von nur zwei Filtern aus einer Vielzahl von frequenzabhängigen Filtern bestimmt. Dies ist vorteilhaft, da ein zu analysierendes Frequenzband, in dem die zu ermittelnde Frequenz erwartet wird, in Teilfrequenzbänder je Filterpaar unterteilt werden kann. Vorteilhafterweise werden Signale außerhalb des Teilfrequenzbands eines Filterpaars unterdrückt. Hierdurch wird jeweils wenigstens eine Frequenz je Teilfrequenzband der jeweiligen Filterpaare ermittelt, falls das Signal nur eine schmalbandige Frequenz aufweist.

Im Zusammenhang mit der Erfindung ist der Begriff "schmalbandige Frequenz" sowohl als eine als Linienspektrum ausgebildete Frequenz als auch als eine als Frequenzband ausgebildete Frequenz zu deuten, wobei dieses Frequenzband bzgl. des Amplitudenfrequenzgangs des jeweiligen Filterpaars durch einen Bereich definiert ist, in dem die Amplitude sich nur geringfügig, wie bspw. weniger als 25 %, in ihrem Wert ändert.

Bei einer besonderen Ausführungsform der erfindungsgemäßen Vorrichtung ist das Filtermodul als Filterbank ausgebildet, die eine Filterstruktur mit mindestens drei frequenzabhängigen Filtern, insbesondere mindestens einen Hochpassfilter und mindestens einen Tiefpassfilter, aufweist. Diese Filterstruktur der Filterbank erleichtert die Auswahl des Filterpaars, da das Signal zeitgleich durch jedes Filter der Filterbank filterbar ist und eine vereinfachte Auswahl des Filterpaars nach dem Filtern gegeben ist. Auf diese Weise wird Flexibilität bei der Auswahl des Filterpaars geschaffen, da das Signal jeweils nur einmal mittels jedes Filters gefiltert werden muss und das Filterpaar anschließend beliebig bestimmt werden kann.

Bei einer speziellen Ausführungsform umfasst das Filterpaar einen Hochpassfilter und einen Tiefpassfilter, wobei eine Grenzfrequenz des Tiefpassfilters kleiner ist als eine Grenzfrequenz des Hochpassfilters. Bevorzugterweise weist der Frequenzgang des Tiefpassfilters oberhalb der Grenzfrequenz eine vorbestimmte Flanke auf, die sich mit einer vorbestimmten Flanke überlappt, die das Hochpassfilter unterhalb seiner Grenzfrequenz in seinem Frequenzgang aufweist. Auf diese Weise sind nur Frequenzen in einem Bereich der Flanken ermittelbar.

Bei einer weiteren besonderen Ausführungsform der erfindungsgemäßen Vorrichtung weist das Filtermodul ein Filterstufenauswahlmodul auf, das derart ausgebildet ist, um aus mindestens drei Filtern des Filtermoduls nur zwei Filter, nämlich das erste frequenzabhängige Filter und das zweite frequenzabhängige Filter, auszuwählen, und um somit das erste gefilterte Signal und das zweite gefilterte Signal für das Relationsmodul zu bestimmen. Auf diese Weise ist das zwei Filter umfassende Filterpaar bestimmbar, wobei erfindungsgemäß die Amplitudenfrequenzgänge der zwei Filter des Filterpaars sich voneinander unterscheiden müssen. Auf diese Weise sind bevorzugte Filterpaare auswählbar. Bevorzugte Filterpaare sind bspw. ein Hochpassfilter und ein Tiefpassfilter jeweils mit Grenzfrequenzen im Bereich einer zu erwartenden Frequenz des Signals.

Bei einer weiteren bevorzugten Ausführungsform des erfindungsgemäßen Verfahrens wird das Signal abgetastet. Auf diese Weise wird das Signal zeitdiskretisiert und wertdiskretisiert. Dies ist vorteilhaft, da das erfindungsgemäße Verfahren somit mittels einer Recheneinheit ausführbar ist. Bevorzugterweise sind Amplitudenfrequenzgänge jedweder frequenzabhängigen Filter mittels einer Recheneinheit errechenbar und/oder erzeugbar. Vorzugsweise sind Koeffizienten der frequenzabhängigen Filter aus Polstellen und aus Nullstellen in einer Z-Ebene mittels einer Z-Transformation bestimmbar. Mittels der Koeffizienten eines zeitdiskreten und wertdiskreten, insbesondere eines digitalen, Filters ist ein Amplitudenfrequenzgang des Filters ermittelbar.

Dank des erfindungsgemäßen Verfahrens ist das Ermitteln der Frequenz des Signals nicht von der Art und Weise der Zeitdiskretisierung und Wertdiskretisierung, d.h. von einer Quantisierung des Signals abhängig. Vielmehr hängt die Frequenzauflösung der zu ermittelnden Frequenz von einer Quantisierung des Amplitudenquotienten und von einer Quantisierung des relativen Frequenzgangs ab.

Bei einer besonderen weiteren Ausführungsform des erfindungsgemäßen Verfahrens wird vor dem Ermitteln des wenigstens einen Amplitudenquotienten ein absoluter Betrag des ersten gefilterten Signals und/oder ein absoluter Betrag des zweiten gefilterten Signals gebildet. Auf diese Weise wird zum Einen eine Polarität des Signals gleichgerichtet, d.h. negative Amplituden werden zu positiven Amplituden, und zum Anderen eine Phaseninformation des ggf. komplexen Signals entfernt. Dies ist vorteilhaft, da die Filter des Filterpaars unabhängig von ihrem Phasenfrequenzgang ausgewählt werden können. Auf diese Weist ist ausschließlich eine frequenzabhängige Amplitudenveränderung des Signals durch das Filter informationstragender Anteil für das Ermitteln der Frequenz.

Bei einer weiteren bevorzugten Ausführungsform wird der relative Frequenzgang ein-oder mehrmals durch Bilden eines Verhältnisses vom Amplitudenfrequenzgang des ersten frequenzabhängigen Filters zum Amplitudenfrequenzgang des zweiten frequenzabhängigen Filters erzeugt. Vorteilhafterweise sind nicht nur vorbestimmte Filter, sondern auch vor dem Filtern des Signals anpassbare Filter verwendbar. Bevorzugterweise werden die relativen Frequenzgänge der Filterpaare zum Ermitteln der zur ermittelnden Frequenz spätestens vor dem Vergleichen mit dem bzw. den Amplitudenquotienten erzeugt. Dies ist vorteilhaft, da ein Speicher nur für diesen relativen Frequenzgang zu belegen ist, und nicht für alle theoretisch möglichen relativen Frequenzgänge.

Bei einer speziellen Ausführungsform wird ein Gleichanteil des Signals vor dem Filtern des Signals entfernt oder der Gleichanteil wird durch das Filtern des Signals entfernt, indem der Amplitudenfrequenzgang des ersten frequenzabhängigen Filters und/oder der Amplitudenfrequenzgang des zweiten frequenzabhängigen Filters derart ausgebildet ist, um Gleichanteile zu unterdrücken. Bevorzugterweise weist ein Gleichanteil unterdrückender Filter eine Bandsperre an der Frequenz Null oder einen Hochpasscharakter auf. Ein gleichanteilfreies Signal erleichtert das Ermitteln des Amplitudenquotienten, da der Amplitudenquotient über die Zeit nicht mehr variiert, sondern bevorzugterweise bei einem nur eine schmalbandige Frequenz aufweisenden Signal über die Zeit konstant ist.

Bei einer weiteren speziellen Ausführungsform, bei dem der ein oder mehrere Werte umfassende Amplitudenquotient mehr als nur einen Wert umfasst, wird die Anzahl der Werte des Amplitudenquotienten auf wenigstens einen Wert reduziert oder zusammengefasst, indem der wenigstens eine Wert mittels eines stochastischen Analyseverfahrens, insbesondere mittels eines ein unteres, mittleres und/oder oberes Quartil errechnenden Verfahrens, bestimmt wird. Auf diese Weise wird ein Wertebereich des Amplitudenquotienten auf einen vorbestimmten Bereich beschränkt, der vorteilhafterweise im Bereich der wenigstens einen Frequenz liegt. Auf diese Weise werden zeitliche Schwankungen des Amplitudenquotienten, insbesondere aufgrund eines einen Gleichanteil aufweisenden gefilterten Signals, minimiert bzw. ausgeglichen. Ferner ist die wenigstens eine Frequenz bei einem ein schmalbandiges Frequenzband aufweisenden Signal auf diese Weise ermittelbar.

Bei einer weiteren bevorzugten Ausführungsform wird die wenigstens eine Frequenz aus dem relativen Frequenzgang und dem ein oder mehrere Werte umfassenden Amplitudenquotienten mittels der Gleichung

$$0 = \Theta[n] - H_\Theta(\omega)$$

durch numerisches, analytisches oder nährungsweises Auflösen ermittelt, wobei $\omega = 2\pi.f_0$ einer Kreisfrequenz, $\Theta[n]$ den bzw. dem Amplitudenquotienten und $H_\Theta(\omega)$ dem relativen Frequenzgang entspricht. Auf diese Weise ist die zu ermittelnde Frequenz durch Auflösen dieser Gleichung mittels des Gleichungsmoduls ermittelbar. Dies ist vorteilhaft, da sowohl nur eine als auch mehrere Frequenzen als Ergebnis dieser Gleichung möglich sind, wobei das Ergebnis gleich der wenigstens einen zu ermittelnden Frequenz ist.

Bei einer speziellen Ausführungsform, bei der eine Umkehrfunktion des relativen Frequenzgangs existiert, wird die wenigstens eine Frequenz aus dem relativen Frequenzgangs und aus dem nur einen Wert umfassenden Amplitudenquotienten durch Einsetzen dieses Amplitudenquotienten in die Umkehrfunktion des relativen Frequenzgangs mittels der Gleichung

$$1/(2\pi)\cdot H_\Theta^{-1}(\Theta[n]) = f_0$$

ermittelt, wobei $H_\Theta^{-1}(\Theta[n])$ die Umkehrfunktion des relativen Frequenzgangs ist und ein Argument $\Theta[n]$ aufweist, das dem nur einen Wert aufweisenden Amplitudenquotienten entspricht. Ferner ist $\pi$ die Kreiszahl und $f_0$ die wenigstens eine zu ermittelnde Frequenz. Diese Gleichung erleichtert unter den genannten Voraussetzungen, nämlich das die Umkehrfunktion existiert und der Amplitudenquotient nur einen Wert umfasst, das Ermitteln der wenigstens einen Frequenz. Auf diese Weise ist ebenfalls mittels des Gleichungsmoduls die wenigstens eine Frequenz des Signals ermittelbar.

Bei einer weiteren besonderen Ausführungsform wird das Verfahren mehrfach mit demselben Signal, jedoch mit voneinander verschiedenen Filterpaaren ausgeführt und daher werden mehrere Frequenzen ermittelt, die mittels eines stochastischen Analyseverfahrens, insbesondere mittels eines Mittelwerts oder Schnittmengen errechnenden Verfahrens, zu nur einer Frequenz reduziert werden, die der wenigstens einen zu ermittelnden Frequenz entspricht. Dank der verschiedenen Filterpaare sind voneinander verschiedene Frequenzbereiche analysierbar. Auf diese Weise wird der analysierte Frequenzbereich erweitert und andere Signale außerhalb des jeweiligen Frequenzbereichs der Filterpaare werden unterdrückt. Eine Schnittmengenbildung reduziert die aus den mehrfach durchgeführten Verfahren ermittelten Frequenzen auf die wenigstens eine Frequenz. Auf diese Weise wird trotz eines störungsbehafteten Signals, insbesondere eines verrauschten Signals, die wenigstens eine Frequenz ermittelt, solange die störenden Anteile des Signals unwesentlich in einem Durchlassbereich des Amplitudenfrequenzgangs des Filterpaars liegen.

Bei einer speziellen Ausführungsform, bei der das erste frequenzabhängige Filter oder das zweite frequenzabhängige Filter jeweils in seinem Amplitudenfrequenzgang mehr als eine Steigung aufweist, wie es bspw. bei einem Filter mit Bandpasscharakter der Fall ist, entspricht nur ein Amplitudenwert des relativen Frequenzgangs mehreren Frequenzen. Dank des mehrfach ausführbaren Verfahrens mit voneinander verschiedenen Filterpaaren und stochastischem Analyseverfahren führen Filter, die bei einer Amplitude mehrere Frequenzen aufweisen, ebenfalls zur wenigstens einen zu ermittelnden Frequenz.

Bei einer weiteren besonderen Ausführungsform werden bei dem mehrfach ausführbaren Verfahren die zwei voneinander verschiedenen Filter der Filterpaare iterativ, nach einer erwarteten Frequenz oder unter Berücksichtigung von Informationen vorheriger und/oder parallel ausgeführter Verfahren bestimmt. Auf diese Weise werden die Filterpaare je ausgeführten Verfahren systematisch und/oder zielgerichtet zusammengestellt. Auf diese Weise werden gleiche Filterpaare vermieden. Bevorzugterweise ist das erfindungsgemäße Verfahren zum mehrfachen Ausführen des Verfahrens parallelisierbar, um Zeit einzusparen. Ferner ist die zu ermittelnde Frequenz mit einer Erwartung der zu ermittelnden Frequenz bzgl. der Auswahl der Filterpaare optimierbar. Auf diese Weise werden Filterpaare, deren Amplitudenfrequenzgänge außerhalb eines Bereichs der zu ermittelnden Frequenz liegen, niedriger priorisiert als andere und somit den höher priorisierten Filterpaaren nachfolgend oder überhaupt nicht ausgeführt.

Eine alternative Ausführungsform der Erfindung betrifft ein Computerprogramm, insbesondere ein Computerprogrammprodukt, welches Programmcodemittel aufweist zum Ausführen des erfindungsgemäßen Verfahrens, wenn das Programm auf einem Computer oder einer entsprechenden Recheneinheit ausgeführt wird. Die Programmcodemittel sind auf von einem Computer lesbaren Datenträgern speicherbar, wobei geeignete Datenträger bspw. Disketten, Festplatten, Flash-Speicher, EPROMs, CDs, DVDs und anderes mehr sein können. Auch ein Download eines Programms über Computernetze, insbesondere Internet, Intranet usw., ist möglich.

Weitere vorteilhafte Ausführungsformen ergeben sich aus den Unteransprüchen sowie aus anhand der beigefügten Zeichnung erläuterten Ausführungsbeispielen. In der Zeichnung zeigen:

Fig. 1    ein Flussdiagramm eines erfindungsgemäßen Verfahrens zum Ermitteln wenigstens einer Frequenz eines Signals;

Fig. 2    ein Ausführungsbeispiel einer erfindungsgemäßen Vorrichtung zur Ermittlung der wenigstens einen Frequenz des Signals;

Fig. 3    ein weiteres Ausführungsbeispiel der erfindungsgemäßen Vorrichtung umfassend eine Filterbank und ein Filterstufenauswahlmodul;

Fig. 4    ein weiteres spezielles Ausführungsbeispiel des erfindungsgemäßen Verfahrens, das mehrfach ausgeführt wird;

Fig. 5A    ein Szenario zur Erläuterung von Verfahrensschritten des erfindungsgemäßen Verfahrens;

Fig. 5B    das Szenario gemäß Fig. 5 zur Erläuterung eines weiteren Verfahrensschritts des erfindungsgemäßen Verfahrens;

Fig. 6A    ein weiteres Szenario zur Erläuterung des erfindungsgemäßen Verfahrens mit einem ersten mehrdeutigen relativen Frequenzgang;

Fig. 6B    das Szenario gemäß Fig. 6A zur Erläuterung des erfindungsgemäßen Verfahrens mit einem zweiten mehrdeutigen relativen Frequenzgang;

Fig. 7A    ein weiteres spezielles Szenario zur Erläuterung von Verfahrensschritten des erfindungsgemäßen Verfahrens und

Fig. 7B    das Szenario gemäß Fig. 7A zur Erläuterung eines weiteren Verfahrensschritts des erfindungsgemäßen Verfahrens bei zeitlich variierenden Amplitudenquotienten.

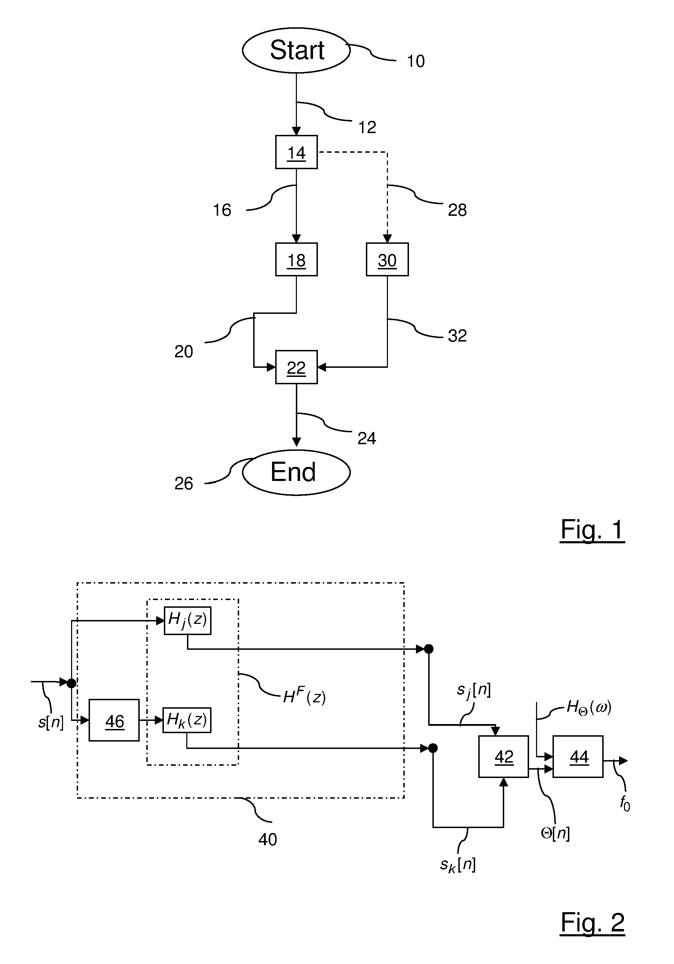

Fig. 1 zeigt ein Flussdiagramm eines erfindungsgemäßen Verfahrens zum Ermitteln wenigstens einer Frequenz eines Signals. Das Verfahren startet in einem Startblock 10 und führt über einen Zweig 12 das erfindungsgemäße Verfahren zu einem Filterblock 14. In dem Filterblock 14 wird das Signal mittels mindestens zwei frequenzabhängigen Filtern gefiltert. Mittels eines der zwei frequenzabhängigen Filter, nachfolgend als erstes frequenzabhängiges Filter bezeichnet, wird das Signal gefiltert und erzeugt ein erstes gefiltertes Signal. Mittels eines weiteren frequenzabhängigen Filters, nachfolgend als zweites frequenzabhängiges Filter bezeichnet, wird dasselbe Signal gefiltert und ein zweites gefiltertes Signal erzeugt. Nachdem das erste gefilterte Signal und das zweite gefilterte Signal in dem Filterblock 14 erzeugt worden sind, führt das Verfahren über einen Zweig 16 zu einem Amplituden-Relationsblock 18.

In dem Amplituden-Relationsblock 18 wird ein Verhältnis vom ersten gefilterten Signal zum zweiten gefilterten Signal gebildet. Das Ergebnis dieses Verhältnisses ist wenigstens ein Quotient, nämlich ein aus nur einem oder mehreren Werten bestehender Amplitudenquotient. Vom Amplituden-Relationsblock 18 führt das Verfahren über einen Zweig 20 zu einem Gleichungsblock 22.

In dem Gleichungsblock 22 werden zwei Größen, nämlich der Amplitudenquotient und ein relativer Frequenzgang, zum Ermitteln wenigstens einer Frequenz benötigt. Mittels eines Vergleichs im Gleichungsblock 22 zwischen dem aus mehreren Werten bestehenden Amplitudenquotienten und dem relativen Frequenzgang wird die wenigstens eine Frequenz ermittelt. Nach Ermitteln der wenigstens einen Frequenz im Gleichungsblock 22 führt das Verfahren über einen Zweig 24 zu einem Endblock 26, der das Ende des Verfahrens kennzeichnet.

Bei einem speziellen Ausführungsbeispiel gemäß Fig. 1 führt das Verfahren vom Filterblock 14 zum einen über den Zweig 16 zum Amplituden-Relationsmodul 18 und zum anderen einen Zweig 28 zu einem Frequenzgang-Relationsmodul 30.

In dem Frequenzgang-Relationsblock 30 wird der relative Frequenzgang erzeugt und/oder gespeichert. Der relative Frequenzgang wird erzeugt, indem ein Verhältnis von einem Amplitudenfrequenzgang des ersten frequenzabhängigen Filters zu einem Amplitudenfrequenzgang des zweiten frequenzabhängigen Filters gebildet wird und der Quotient dieses Verhältnisses errechnet wird, der dem relativen Frequenzgang entspricht. Die Erfindung ist jedoch nicht auf das Verhältnis zwischen den Amplitudenfrequenzgängen des ersten und des zweiten frequenzabhängigen Filters beschränkt, sondern offenbart vielmehr ein Verhältnis zwischen Amplitudenfrequenzgängen zweier Filter. Vom Frequenzgang-Relationsblock 30 führt das Verfahren über einen Zweig 32 zum Gleichungsblock 22. Entsprechend des vorhergehenden Ausführungsbeispiels wird in dem Gleichungsblock 22 mittels des relativen Frequenzgangs und des Amplitudenquotienten die Frequenz ermittelt.

Fig. 2 zeigt eine erfindungsgemäße Vorrichtung umfassend ein Filtermodul 40, ein Relationsmodul 42 und ein Gleichungsmodul 44. Das Filtermodul 40 weist mindestens ein erstes frequenzabhängiges Filter $H_j(z)$ und vom ersten frequenzabhängigen Filter $H_j(z)$ verschiedenes zweites frequenzabhängiges Filter $H_k(z)$ auf. Nachfolgend wird ein Paar bestehend aus zwei frequenzabhängigen Filtern, nämlich aus dem ersten frequenzabhängigen Filter $H_j(z)$ und aus dem zweiten frequenzabhängigen Filter $H_k(z)$, als Filterpaar $H^F(z)$ bezeichnet. Ein Signal $s[n]$ ist mittels des Filtermoduls 40 filterbar. Durch das Filtern des Signals $s[n]$ mittels des Filterpaars $H^F(z)$ sind gefilterte Signale erzeugbar. Ein erstes gefiltertes Signal $s_j[n]$ ist mittels des ersten frequenzabhängigen Filters $H_j(z)$ aus dem Signal $s[n]$ erzeugbar. Ferner ist ein zweites gefiltertes Signal $s_k[n]$ mittels des zweiten frequenzabhängigen Filters $H_k(z)$ aus dem Signal $s[n]$ erzeugbar.

Ausgangsseitig des Filtermoduls 40 sind das

erste gefilterte Signal $s_j[n]$ und das zweite Signal $s_k[n]$ dem Relationsmodul 42 zuführbar. Mittels des Relationsmoduls 42 ist ein Verhältnis vom ersten gefilterten Signal $s_j[n]$ zum zweiten gefilterten Signal $s_k[n]$ erzeugbar. Mittels dieses Verhältnisses ist ein Quotient, nämlich ein aus einen oder mehreren Werten bestehender Amplitudenquotient $\Theta[n]$, ermittelbar. Das erste gefilterte Signal $s_j[n]$ und das zweite gefilterte Signal $s_k[n]$ weisen jeweils einen Index $n$ auf, wobei die Signale $s[n]$, $s_j[n]$ und $s_k[n]$ jeweils nur einen oder mehrere Werte umfassen. Der Index $n$ kennzeichnet daher nur einen Zeitpunkt oder alternativ eine Zeitspanne bis zu diesem Zeitpunkt. Bevorzugterweise sind die Signale $s[n]$, $s_j[n]$ und $s_k[n]$ zeitdiskret. Alternativ sind die Signale jedoch zeitkontinuierlich. Ausgangsseitig des Relationsmoduls 42 sind die aus nur einem oder mehreren Werten bestehenden Amplitudenquotienten $\Theta[n]$ dem Gleichungsmodul 44 zuführbar.

Mittels des Gleichungsmoduls 44 ist aus dem nur aus einem oder mehreren Werten bestehenden Amplitudenquotienten $\Theta[n]$ und einem relativen Frequenzgang $H_\Theta(\omega)$ wenigstens eine zu ermittelnde Frequenz $f_0$ des Signals s[n] ermittelbar. Der relative Frequenzgang $H_\Theta(\omega)$ umfasst mehrere Werte, die dem Quotienten aus einem Verhältnis von einem Amplitudenfrequenzgang des ersten frequenzabhängigen Filters $H_j(z)$ zu einem Amplitudenfrequenzgang des zweiten frequenzabhängigen Filters $H_k(z)$ entsprechen. Die Werte des relativen Frequenzgangs $H_\Theta(\omega)$ sind bspw. aus einer Funktionsgleichung, einer Tabelle und/oder einem Speicher dem Gleichungsmodul 44 zuführbar. Ferner ist das Gleichungsmodul 44 derart ausgebildet, um die wenigstens eine Frequenz $f_0$ zu ermittelt, bei der der wenigstens eine Amplitudenwert aus dem relativen Frequenzgang $H_\Theta(\omega)$ dem ein oder mehreren Werte umfassenden Amplitudenquotienten $\Theta[n]$ entspricht.

Bei einem speziellen Ausführungsbeispiel gemäß Fig. 2 weist das Filtermodul 40 ein Gleichanteilunterdrückungsmodul 46 auf, dem das Signal $s[n]$ zuführbar ist. Ferner ist das Gleichanteilunterdrückungsmodul 46 derart ausgebildet, um einen Gleichanteil des Signals $s[n]$ zu unterdrücken. Das Gleichanteilunterdrückungsmodul 46 erzeugt daher aus dem Signal $s[n]$ ein gleichanteilfreies Signal, das mindestens einem Filter des Filtermoduls 40 zuführbar ist.

Alternativ weist mindestens ein Filter des Filtermoduls, bspw. das erste frequenzabhängige Filter $H_j(z)$ und/oder das zweite frequenzabhängige Filter $H_k(z)$ einen Amplitudenfrequenzgang auf, der derart ausgebildet ist, um Gleichanteile zu unterdrücken. Eine Gleichanteilunterdrückung mittels eines Amplitudenfrequenzgangs ist gegeben, falls der Amplitudenfrequenzgang einen Tiefpasscharakter oder eine Bandsperre bei einer Frequenz gleich Null aufweist.

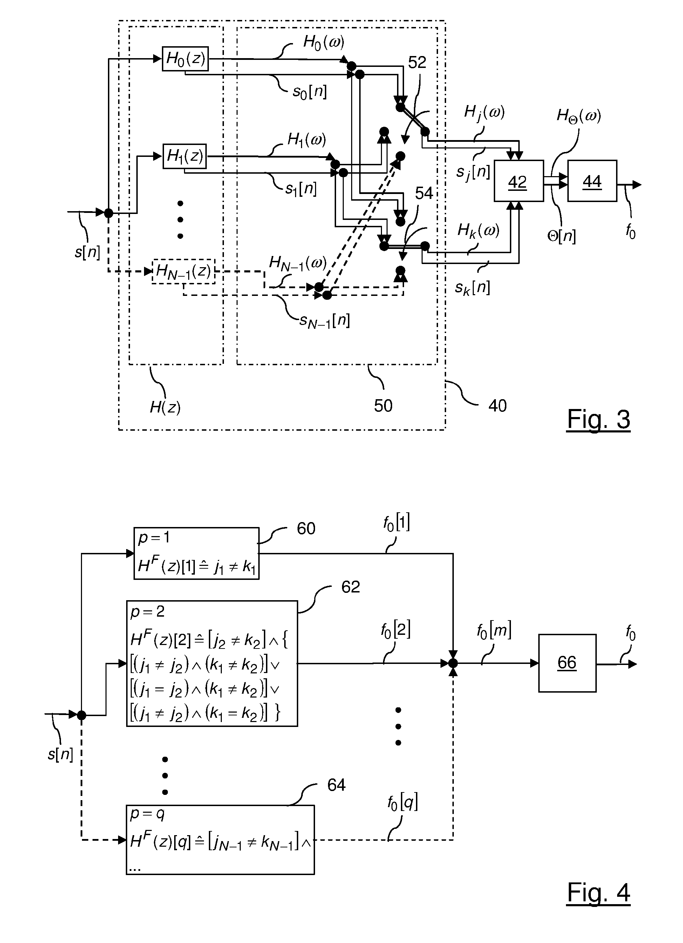

Fig. 3 zeigt ein weiteres Ausführungsbeispiel der erfindungsgemäßen Vorrichtung, die das Filtermodul 40, das Relationsmodul 42 und das Gleichungsmodul 44 umfasst. Ferner weist das Filtermodul 40 eine Filterbank $H(z)$ und ein Filterstufenauswahlmodul 50 auf.

Die Filterbank $H(z)$ weist mindestens drei frequenzabhängige Filter auf, die bspw. als Hochpassfilter, Tiefpassfilter, Bandsperrfilter oder Bandpassfilter ausgebildet sind. Jedem der Filter $H_0(z)$, $H_1(z)$,..., $H_{N-1}(z)$ der Filterbank $H(z)$ ist dasselbe Signal $s[n]$ zuführbar.

Bei einem speziellen Ausführungsbeispiel der Filterbank $H(z)$ sind nicht nur gefilterte Signale erzeugbar, sondern auch Amplitudenfrequenzgänge. Gemäß Fig. 3 erzeugt das Filter $H_0(z)$ aus dem Signal $s[n]$ ein gefiltertes Signal $s_0[n]$ sowie einen Amplitudenfrequenzgang $H_0(\omega)$, die dem Relationsmodul 42 zuführbar sind. Ferner erzeugt das weitere frequenzabhängige Filter $H_1(z)$ aus dem Signal s[n] ein gefiltertes Signal $s_1[n]$ sowie einen Amplitudenfrequenzgang $H_1(\omega)$, die dem Relationsmodul 42 ebenfalls zuführbar sind. Gemäß Fig. 3 sind durch drei Punkte in der Filterbank zwischen dem frequenzabhängigen Filter $H_1(z)$ und dem frequenzabhängigen Filter $H_{N-1}(z)$ insgesamt eine Anzahl von $N$ frequenzabhängigen Filtern angedeutet, wobei mittels jedes der frequenzabhängigen Filter aus dem Signal $s[n]$ ein gefiltertes Signal $s_0[n]$, $s_1[n]$,..., $s_{N-1}[n]$ und/oder ein Amplitudenfrequenzgang $H_0(\omega)$, $H_1(\omega)$,..., $H_{N-1}(\omega)$ erzeugbar ist.

Alternativ erzeugt ein anderes Modul als die Filterbank $H(z)$ aus Informationen über die Filter $H_0(z)$, $H_1(z)$,..., $H_{N-1}(z)$ der Frequenzbank $H(z)$, wie bspw. aus Koeffizienten der Filter $H_0(z)$, $H_1(z)$,..., $H_{N-1}(z)$, die Amplitudenfrequenzgänge $H_0(\omega)$, $H_1(\omega)$,..., $H_{N-1}(\omega)$.

Dem Relationsmodul 42 werden nicht jedwede Amplitudenfrequenzgänge $H_0(\omega)$, $H_1(\omega)$,..., $H_{N-1}(\omega)$ und nicht jedwede gefilterten Signale $s_0[n]$, $s_1[n]$,..., $s_{N-1}[n]$ aus der Filterbank $H(z)$ zugeführt, sondern nur eine Auswahl, die mittels eines ersten Auswahlmoduls 52 und mittels eines zweiten Auswahlmoduls 54 getroffen wird. Mittels des ersten Auswahlmoduls 52 ist das erste gefilterte Signal $s_j[n]$ bestimmbar. Analog ist mittels des zweiten Auswahlmoduls 54 ein zweites gefiltertes Signal $s_k[n]$ bestimmbar. Gemäß Fig. 3 ist sowohl das erste Auswahlmodul 52 als auch das zweite Auswahlmodul 54 mittels eines Schalters angedeutet. Die Stellung des Schalters des ersten Auswahlmoduls 52 deutet an, dass bspw. das gefilterte Signal $s_0[n]$ als erstes gefiltertes Signal $s_j[n]$ bestimmt wurde und dem Relationsmodul 42 zuführbar ist. Ferner deutet die Stellung des Schalters des zweiten Auswahlmoduls 54 eine Auswahl des gefilterten Signals $s_1[n]$ für das zweite gefilterte Signal $s_k[n]$ an. Erfindungsgemäß müssen die zwei ausgewählten gefilterten Signale mittels voneinander verschiedenen frequenzabhängigen Filtern gefiltert sein.

Gemäß Fig. 3 weist sowohl das erste Auswahlmodul 52 als auch das zweite Auswahlmodul 54 zwei parallele kurze Linien auf, um eine logische Verknüpfung zwischen der Auswahl der aus den frequenzabhängigen Filtern $H_0(z)$, $H_1(z)$,..., $H_{N-1}(z)$ resultierenden Amplitudenfrequenzgänge $H_0(\omega)$, $H_1(\omega)$,..., $H_{N-1}(\omega)$ und der gefilterten Signale $s_0[n]$, $s_1[n]$,..., $s_{N-1}[n]$ aufzuzeigen. Erfindungsgemäß besteht sowohl das Verhältnis der gefilterten Signale als auch das Verhältnis der Amplitudenfrequenzgänge logisch aus demselben Verhältnis vom ersten frequenzabhängigen Filter $H_j(z)$ zum zweiten frequenzabhängigen Filter $H_k(z)$.

Ferner sind gemäß Fig. 3 aus einer Vielzahl von frequenzabhängigen Filtern $H_0(z)$, $H_1(z)$,..., $H_{N-1}(z)$ der Filterbank $H(z)$ mittels eines Filterstufenauswahlmoduls 50 exakt zwei frequenzabhängige Filter auswählbar, wobei die Amplitudenfrequenzgänge der zwei ausgewählten Filter derart ausgebildet sind, um in einem Bereich der wenigstens einen zu ermittelnden Frequenz $f_0$ eine positive Steigerung oder eine negative Steigerung aufzuweisen. Vorteilhafterweise weist der relative Frequenzgang $H_\Theta(\omega)$ somit ebenfalls eine Steigerung im Bereich der wenigstens einen zu ermittelnden Frequenz $f_0$ auf.

Fig. 4 zeigt ein weiteres Ausführungsbeispiel des erfindungsgemäßen Verfahrens, bei dem das erfindungsgemäße Verfahren mehrfach ausgeführt wird und die wenigstens eine Frequenz $f_0[1]$, $f_0[2]$,..., $f_0[q]$ jedes ausgeführten Verfahrens zu nur einer Frequenz $f_0$ reduziert wird. Das Verfahren wird mehrfach mit demselben Signal $s[n]$, jedoch mit einer Auswahl von voneinander verschiedenen Filterpaaren $H^F(z)[1]$, $H^F(z)[2]$,..., $H^F(z)[q]$ ausgeführt. Eine erste Iteration 60 des erfindungsgemäßen Verfahrens wird mit einem Filterpaar $H^F(z)[1]$ durchgeführt, das frequenzabhängige Filter umfasst, die mit einem Index $j_1$ und $k_1$ gekennzeichnet werden. Mittels der ersten Iteration 60 ist wenigstens eine Frequenz der ersten Iteration $f_0[1]$ ermittelbar. Ferner wird mit demselben Signal $s[n]$ eine zweite Iteration 62 mit einem von der ersten Iteration verschiedenem Filterpaar $H^F(z)[2]$ durchgeführt. Erfindungsgemäß sind die Amplitudenfrequenzgänge der Filter des zweiten Filterpaars $H^F(z)[2]$ ebenfalls voneinander verschieden. Beispielhaft wird dies anhand der kennzeichnenden Filterindices $j_1$, $j_2$, $k_1$ und $k_2$ dargestellt. Für die zweite Iteration 62 bzgl. der Filterauswahl ist daher folgende logische Bedingung einzuhalten:

$$\begin{aligned} [j_2 \neq k_2] \wedge \{ & \\ [(j_1 \neq j_2) \wedge (k_1 \neq k_2)] & \vee \\ [(j_1 = j_2) \wedge (k_1 \neq k_2)] & \vee \\ [(j_1 \neq j_2) \wedge (k_1 = k_2)] & \} \end{aligned}$$

wobei
$j_1$ dem Index des ersten frequenzabhängigen Filters der ersten Iteration,
$j_2$ dem Index des ersten frequenzabhängigen Filters der zweiten Iteration,
$k_1$ dem Index des zweiten frequenzabhängigen Filters der ersten Iteration,
$k_2$ dem Indes des zweiten frequenzabhängigen Filters der zweiten Iteration,
$\wedge$ einer logischen UND-Verknüpfung und

$\vee$ einer logischen ODER-Verknüpfung entspricht.

Eine $q$-te Iteration 64 führt zu wenigstens einer weiteren Frequenz $f_0[q]$. Auf diese Weise kann eine Anzahl der Iterationen $q$ größer sein als die Anzahl $N$ der in der Filterbank $H(z)$ enthaltenen Filter. Die wenigstens eine Frequenz der ersten Iteration $f_0[1]$, die wenigstens eine Frequenz der zweiten Iteration $f_0[2]$ und bis zur wenigstens einen Frequenz der $q$-ten Iteration $f_0[q]$ sind zu mehreren Frequenzen aus den Iterationen $f_0[m]$ zusammenführbar. Die mehreren Frequenzen aus den Iterationen $f_0[m]$ sind mittels eines stochastischen Analyseverfahrens, wie bspw. mittels eines Schnittmengen oder Mittelwert ermittelndem Verfahrens, zu nur einer Frequenz, die der zu ermittelnden Frequenz $f_0$ entspricht, reduzierbar. Auf diese Weise werden fehlerhafte Frequenzen, d.h. Frequenzen, die nicht der zu ermittelnden Frequenz entsprechen, unterdrückt oder tragen nur bedingt zu der wenigstens einen Frequenz $f_0$ bei.

Die voneinander verschiedenen Filterpaare der Iterationen $H^F(z)[1]$, $H^F(z)[2]$,..., $H^F(z)[q]$ sind iterativ, nach einer erwartenden Frequenz oder unter Berücksichtigung von Informationen vorheriger und/oder paralleler ausgeführter Verfahren bestimmbar. Vorteilhafterweise wird nach jeder Iteration das stochastische Analyseverfahren durchgeführt, um die wenigstens eine Frequenz $f_0$ zu ermitteln. Die Anzahl der durchgeführten bzw. noch durchzuführenden Iterationen ist bspw. unter Berücksichtigung von Informationen eines Qualitätsmaßes des stochastischen Analyseverfahrens abhängig. Ferner sind die Iterationen bspw. parallel ausführbar, falls mehr als eine erfindungsgemäße Vorrichtung zum Ermitteln der wenigstens einen Frequenz $f_0$ verwendet wird. Auf diese Weise ist in einer erheblichen Weise Rechenzeit gegenüber einer etwaig sequentiell ausgeführten Iteration reduzierbar.

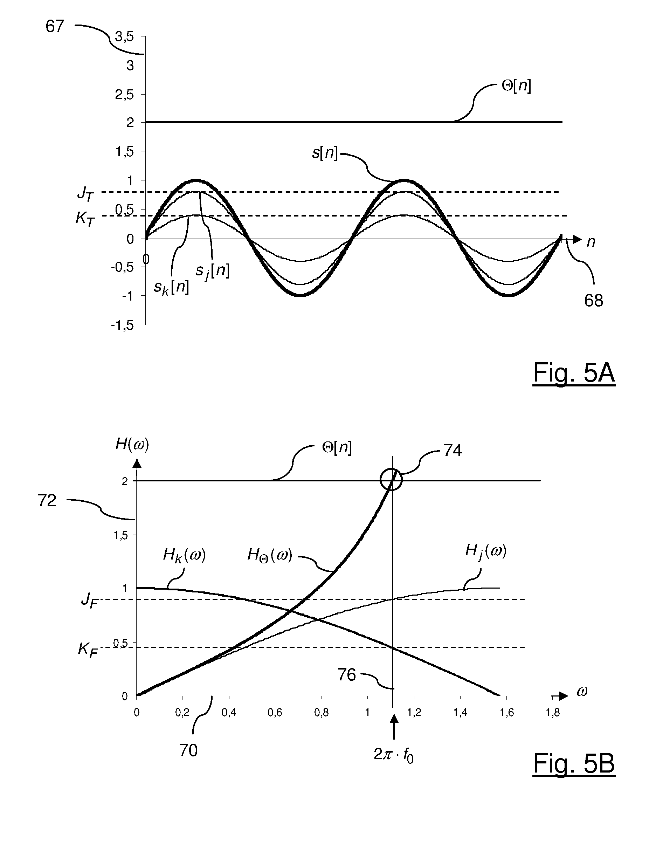

Fig. 5A zeigt ein bevorzugtes Szenario des erfindungsgemäßen Verfahrens bzgl. eines Schritts a), nämlich das Filtern des Signals $s[n]$ und bzgl. eines Schritts b), nämlich dem Ermitteln des wenigstens einen Filterquotienten $\Theta[n]$. Eine Ordinate 67 eines Graphen gemäß Fig. 5A zeigt eine Amplitude an und eine Abszisse 68 kennzeichnet eine Zeit. Das Signal $s[n]$ ist bspw. gemäß Fig. 5A eine Sinusschwingung mit einer Amplitude von 1. Eine Skalierung der Abszisse, d.h. der Zeitachse, ist linear und relativ zwischen dem ersten gefilterten Signal $s_j[n]$, dem zweiten gefilterten Signal $s_k[n]$ und dem Signal $s[n]$ zu betrachten, daher ist eine Frequenz dieser Signale in diesem Beispiel vorbestimmt.

Eine Amplitude des ersten gefilterten Signals $s_j[n]$ beträgt den Wert $J_T$, der proportional zu einer Amplitudendämpfung $J_F$ des ersten frequenzabhängigen Filters $H_j(z)$ an der zu ermittelnden Frequenz $f_0$ ist. Analog resultiert eine Amplitude $K_T$ des zweiten gefilterten Signals $s_k[n]$ aus einem Dämpfungsfaktor bzw. einem Verstärkungsfaktor $K_F$ des zweiten frequenzabhängigen Filters $H_k(z)$ an der zu ermittelnden Frequenz $f_0$. Da dem ersten frequenzabhängigen Filter $H_j(z)$ und dem zweiten frequenzabhängigen Filter $H_k(z)$ dasselbe Signal $s[n]$ zugeführt wird, unterscheiden sich das erste gefilterte Signal $s_j[n]$ und dem gefilterten Signal $s_k[n]$ jeweils in ihrer Amplitude vom Signal $s[n]$. Eine Phasenänderung ist bevorzugterweise bei dem ersten gefilterten Signal $s_j[n]$ und dem zweiten gefilterten Signal $s_k[n]$ identisch, oder durch ihre Betragsbildung eliminierbar. Auf diese Weise sind die Phasen zwischen dem ersten gefilterten Signal $s_j[n]$ und dem zweiten gefilterten Signal $s_k[n]$ gleich und somit ist der Amplitudenquotient $\Theta[n]$ über die Zeit konstant, solange das Signal s[n] nur eine schmalbandige Frequenz innerhalb des Durchlassbereichs des verwendeten Filterpaars aufweist.

Durch Bilden eines Verhältnisses vom ersten gefilterten Signal $s_j[n]$ zum zweiten gefilterten Signal $s_k[n]$ ist gemäß Fig. 5A ein Quotient, nämlich der aus nur einem bestehender Amplitudenquotient $\Theta[n]$, ermittelbar. Grundsätzlich ergibt sich für einen Zeitpunkt auf der Zeitachse exakt nur ein Wert des Amplitudenquotienten $\Theta[n]$. Über eine Zeitspanne der Zeitachse 68 betrachtet kann der Amplitudenquotient $\Theta[n]$ jedoch aus mehreren sich voneinander unterscheidenden Werten bestehen.

Gemäß Fig. 5A weist der Filterquotient $\Theta[n]$ - über die Zeit aufgetragen - einen konstanten Wert auf, und zwar im dargestellten Beispiel von 2. Dies resultiert aus dem Verhältnis von der Amplitude mit dem Wert $J_T$ des ersten gefilterten Signals $s_j[n]$ zu der Amplitude mit dem Wert $K_T$ des zweiten gefilterten Signals $s_k[n]$, wobei $K_T$ die Hälfte von $J_T$ entspricht.

Fig. 5B zeigt den vom Amplitudenfrequenzgang $H_j(\omega)$ des ersten frequenzabhängigen Filters $H_j(z)$ zum Amplitudenfrequenzgang $H_k(\omega)$ des zweiten frequenzabhängigen Filters $H_k(z)$ resultierenden relativen Frequenzgang $H_\Theta(\omega)$. Gemäß Fig. 5B stellt die Abszisse 70 eine Frequenzachse über eine Kreisfrequenz $\omega$ und die Ordinate 72 eine Amplitudenachse dar. Auf diese Weise ist ein Amplitudenfrequenzgang definiert als eine Dämpfung bzw. Verstärkung des Signals abhängig von der wenigstens einen Frequenz $f_0$. Gemäß diesem Szenario weist die wenigstens eine Frequenz $f_0$ des Signals s[n] nur eine Frequenz auf. Daher weist das Signal s[n] eine Schwingung mit der Frequenz $f_0$ auf. An der Frequenz $f_0$ zeigt der Amplitudenfrequenzgang $H_j(\omega)$ eine Änderung der Amplitude von einem Faktor $J_F$ an. Das Signal $s[n]$ wird durch Filtern mittels des Filters $H_j(z)$ um den Faktor $J_F$ gedämpft bzw. verstärkt. Da gemäß Fig. 5A die Amplitude des Signals $s[n]$ gleich 1 ist, entspricht der Faktor $J_F$ der Amplitude $J_T$ des gefilterten Signals $s_j[n]$. Analog zeigt der zweite Amplitudenfrequenzgang $H_k(\omega)$ des zweiten frequenzabhängigen Filters $H_k(z)$ eine Veränderung der Amplitude des Signals s[n] um den Faktor $K_F$ bei der Frequenz $f_0$ an.

Der relative Frequenzgang $H_\Theta(\omega)$ ist ein Quotient vom ersten Amplitudenfrequenzgang $H_j(\omega)$ zum zweiten Amplitudenfrequenzgang $H_k(\omega)$. In einem Bereich 74 des relativen Frequenzgangs $H_\Theta(\omega)$ liegt eine Amplitude des relativen Frequenzgangs $H_\Theta(\omega)$ in einem Bereich des Wertes des Filterquotienten $\Theta[n]$. Durch die Lage des Bereichs 74 des relativen Frequenzgangs $H_\Theta$

$(\omega)$ wird bezogen auf die Frequenzachse 70 die zu ermittelnde Frequenz $f_0$ angezeigt. Gemäß Fig. 5B lässt sich der Bereich 74 des relativen Frequenzgangs $H_\Theta(\omega)$ kennzeichnen, indem eine waagerechte Linie mit einem Wert des Filterquotienten $\Theta[n]$ auf die Amplitudenachse 72 aufgetragen wird und ein Schnittpunkt zwischen dieser waagerechten Linie und dem Graphen des relativen Frequenzgangs $H_\Theta(\omega)$ erzeugt wird. Auf diese Weise ist der Bereich 74 des relativen Frequenzgangs $H_\Theta(\omega)$ kennzeichenbar. Mittels des gekennzeichneten Bereichs 74 des relativen Frequenzgangs $H_\Theta(\omega)$ ist mittels einer hilfsweise eingezeichneten senkrechten Linie 76, die durch diesen Bereich 74 und durch die Frequenzachse 70 führt, an einem Schnittpunkt mit der Frequenzachse 70 die zu ermittelnde Frequenz $f_0$ ablesbar.

Die Erfindung ist jedoch nicht nur auf eine graphische Ermittlung der zu ermittelnden Frequenz $f_0$ beschränkt. Bei einem alternativen Lösungsweg ist die wenigstens eine Frequenz $f_0$ mittels der Gleichung

$$1/(2\pi)\cdot H_\Theta^{-1}(\Theta[n]) = f_0$$

ermittelbar, wobei
$H_\Theta^{-1}(\Theta[n])$ die Umkehrfunktion des relativen Frequenzgangs $H_\Theta(\omega)$,
$\Theta[n]$ der nur einen Wert aufweisende Amplitudenquotient und
$f_0$ die zu ermittelnde Frequenz ist.

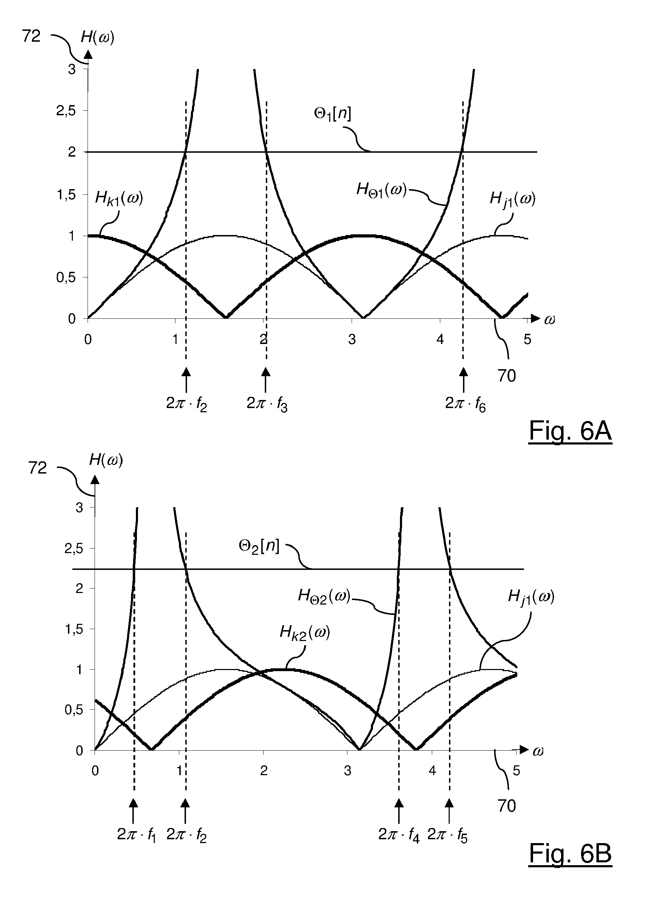

Fig. 6A zeigt ein weiteres Szenario des erfindungsgemäßen Verfahrens zum Ermitteln wenigstens einer Frequenz $f_0$. Durch die Abszisse 70 ist eine Frequenzachse mit der Kreisfrequenz $\omega$ und durch die Ordinate 72 eine Amplitudeachse gegeben. Gemäß Fig. 6A sind drei Funktionen aufgetragen, nämlich ein erster Amplitudenfrequenzgang $H_{j1}(\omega)$, ein zweiter Amplitudenfrequenz $H_{k1}(\omega)$ und ein hieraus resultierender relativer Frequenzgang $H_{\Theta 1}(\omega)$. Der relative Frequenzgang $H_{\Theta 1}(\omega)$ ist an mindestens einer Amplitude mehrdeutig, d.h. nur ein Amplitudenwert ist nicht nur einer Frequenz zuordbar. Gekennzeichnet ist diese Zuordnung mittels einer waagerechten Linie, die den Wert eines Filterquotienten $\Theta_1[n]$ aufweist. Durch eine graphischen Ermittlung gemäß Fig. 6A ergeben sich drei Schnittpunkte zwischen der waagerechten Linie des Filterquotienten $\Theta_1[n]$ und dem relativen Frequenzgang $H_{\Theta 1}(\omega)$. Ein erster von diesen drei Schnittpunkten zwischen dem Filterquotienten $\Theta_1[n]$ und dem relativen Frequenzgang $H_{\Theta 1}(\omega)$ liegt gemäß Fig. 6A im Bereich der Frequenz $f_2$. Ein zweiter Schnittpunkt der drei gezeigten Schnittpunkte befindet sich im Bereich der Frequenz $f_3$ sowie ein dritter Schnittpunkt im Bereich der Frequenz $f_5$. Gemäß Fig. 6A sind bei mehrdeutigen relativen Frequenzgängen, wie bspw. $H_{\Theta 1}(\omega)$, mehrere Frequenzen ermittelbar. Dank des graphisch dargestellten relativen Frequenzgangs $H_{\Theta 1}(\omega)$ und des graphisch aufgetragenen Filterquotienten $\Theta_1[n]$ sind die Frequenzen $f_2$, $f_3$ und $f_6$ graphisch zu ermitteln, wobei einer dieser Frequenzen der wenigstens einen Frequenz $f_0$ entspricht.

Alternativ ist die wenigstens eine Frequenz $f_0$ mittels der Gleichung

$$0 = \Theta[n] - H\Theta(\omega)$$

ermittelbar, wobei

$\Theta[n]$ der einen oder mehrere Werte umfassende Amplitudenquotient und

$H_\Theta(\omega)$ der relative Frequenzgang ist.

Falls der relative Frequenzgang $H_{\Theta1}(\omega)$ mehrdeutig ist, führt der nur einen Wert umfassende Amplitudenquotient $\Theta_1[n]$ zu der zu ermittelnden Frequenz $f_0$ und zu weiteren Frequenzen, die jedoch einen Messfehler dieses Verfahrens darstellen. Dieser Messfehler ist durch Ausführen einer weiteren Iteration des erfindungsgemäßen Verfahrens mit demselben Signal, jedoch mit voneinander verschiedenen Filterpaaren entfernbar. Aufgrund weiterer Iterationen des erfindungsgemäßen Verfahrens resultieren mehrere Frequenzen $f_0[m]$, die durch ein stochastisches Analyseverfahren zu nur einer Frequenz reduzierbar sind, wobei diese der wenigstens einen zu ermittelnden Frequenz $f_0$ entspricht.

Fig. 6B zeigt dasselbe Szenario gemäß Fig. 6A, jedoch mit einem vom Filterpaar gemäß Fig. 6A verschiedenen Filterpaar. Ein erstes frequenzabhängiges Filter weist einen Amplitudenfrequenzgang $H_{j1}(\omega)$ auf, der dem Amplitudenfrequenzgang $H_{j1}(\omega)$ gemäß Fig. 6A entspricht. Im Gegensatz zur Fig. 6A weist Fig. 6B einen zweiten Amplitudenfrequenz $H_{k2}(\omega)$ auf, der sich vom zweiten Amplitudenfrequenzgang $H_{k1}(\omega)$ gemäß Fig. 6A unterscheidet. Auf diese Weise unterscheidet sich ein Filterquotient $\Theta_2[n]$ vom Filterquotienten $\Theta_1[n]$ aus Fig. 6A. Ferner unterscheidet sich ein relativer Frequenzgang $H_{\Theta2}(\omega)$ vom relativen Frequenzgang $H_{\Theta1}(\omega)$ aufgrund des zu Fig. 6A unterschiedlichen Filterpaars. Der Filterquotient $\Theta_2[n]$ wird mittels einer waagerechten Linie über alle Frequenzen aufgetragen. Die Schnittpunkte zwischen der waagerechten Linie des Filterquotienten $\Theta_2[n]$ und dem relativen Frequenzgang $H_{\Theta2}(\omega)$ zeigen auf der Frequenzachse 70 insgesamt vier Frequenzen auf, nämlich $f_1$, $f_2$, $f_4$ und $f_5$, die der wenigstens einen Frequenz $f_0$ sowie Messfehler bedingten Frequenzen entsprechen.

Mittels einer Schnittmengenbildung von den Frequenzen einer ersten Iteration gemäß Fig. 6A und von den Frequenzen einer zweiten Iteration gemäß Fig. 6B ist nur eine zu ermittelnde Frequenz $f_0$ ermittelbar. Die wenigstens eine Frequenz $f_0$ entspricht gemäß diesem Szenario der Frequenz $f_2$, da diese Frequenz im Gegensatz zu allen weiteren Frequenzen ($f_1$ $f_3$, $f_4$, $f_5$ und $f_6$) jeweils in allen Iterationen als Teilmenge ermittelt wurde. Auf diese Weise sind fehlerhaft ermittelte Frequenzen aus mehrdeutigen relativen Frequenzgängen eliminierbar.

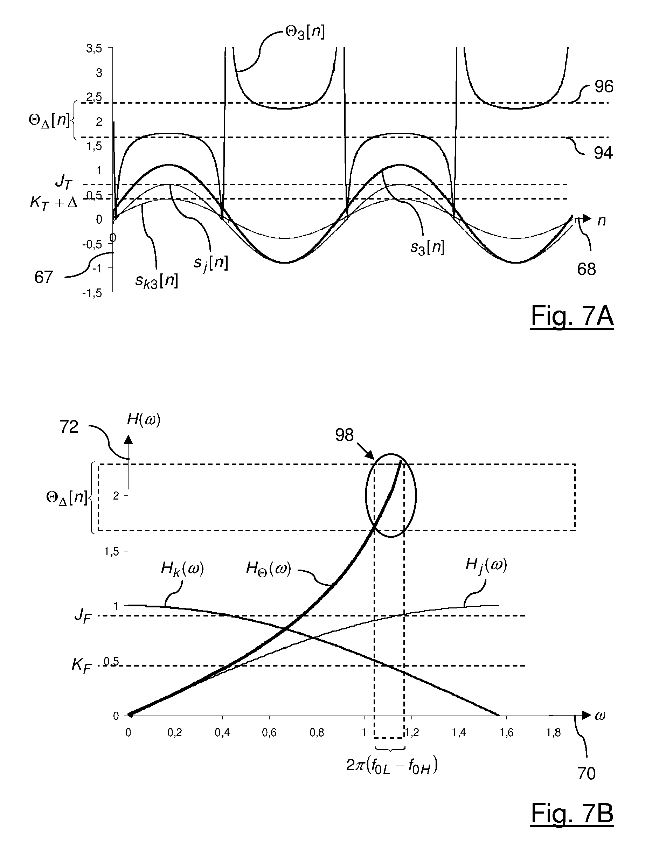

Fig. 7A zeigt gemäß einem speziellen Ausführungsbeispiel der Erfindung vier Graphen analog Fig. 5A, die über die Zeitachse 68 aufgetragen sind. Das Signal $s_3[n]$ gemäß Fig. 7A ist mit einem Gleichanteil behaftet. Dieser Gleichanteil beträgt einen Wert $\Delta$. Gemäß dem Szenario aus Fig. 5B weist der erste frequenzabhängige Filter $H_j(z)$ gemäß seinem Amplitudenfrequenzgang $H_j(\omega)$ einen Hochpasscharakter auf. Aufgrund dieses Hochpasscharakters werden Gleichanteile des Signals $s_3[n]$ eliminiert und das erste gefilterte gleichanteilfreie Signal $s_j[n]$ erzeugt. Ferner weist der zweite frequenzabhängige Filter $H_k(z)$ gemäß Fig. 6 den Amplitudenfrequenzgang $H_k(\omega)$ auf, der einen Tiefpasscharakter aufweist. Aufgrund des Tiefpasscharakters des zweiten frequenzabhängigen Filters $H_k(z)$ wird ein Gleichanteil behaftetes gefiltertes Signal $s_{k3}[n]$ erzeugt. Ein Amplitudenquotient $\Theta_3[n]$ ist im Gegensatz zur Fig. 5A nicht konstant, sondern variiert über die Zeit.

Falls der ein oder mehrere Werte umfassende Amplitudenquotient $\Theta[n]$ mehr als nur einen Wert umfasst, ist die Anzahl der Werte bis auf zu nur einem Wert reduzierbar oder zusammenfassbar, indem Werte mittels eines stochastischen Verfahrens, wie bspw. einem ein unteres und ein oberes Quartil errechnenden Verfahren, bestimmt werden. Das untere Quartil ist mittels einer waagerechten Linie 94 und das obere Quartil ist mittels einer waagerechten Linie 96 dargestellt. Ein mittels der waagerechten Linie 94, 96 eingeschlossener Amplitudenbereich reduziert die Anzahl der Werte des Amplitudenquotienten $\Theta[n]$ zu einem Wertebereich $\Theta_\Delta[n]$. Auf diese Weise ist trotz des mit einem Gleichanteil behafteten zweiten gefilterten Signals $s_{k3}[n]$ ein aus mehreren Werten bestehender Amplitudenquotient $\Theta_\Delta[n]$ sinnvoll bestimmbar.

Fig. 7B zeigt das Szenario gemäß Fig. 5B, jedoch mit dem mehrere Werte umfassenden Filterquotienten $\Theta_\Delta[n]$. Statt nur einem Schnittpunkt zwischen dem relativen Frequenzgang $H_\Theta(\omega)$ und der waagerechten Linie von $\Theta[n]$ gemäß Fig. 5B, ergibt sich aufgrund von mehreren Werten des Amplitudenquotienten $\Theta_\Delta[n]$ nicht nur ein Schnittpunkt, sondern ein Schnittmengenbereich 98. Dieser Schnittmengenbereich 98 enthält die wenigstens eine Frequenz $f_0$. Gemäß Fig. 7B ist die wenigstens eine Frequenz $f_0$ in einem Frequenzbereich von $f_{0L}$ bis $f_{0H}$ enthalten. Vorteilhafterweise ist trotz des gleichanteilbehafteten Signals $s_3[n]$ die wenigstens eine zu ermittelnde Frequenz $f_0$ näherungsweise zu ermitteln. Bevorzugterweise ist jedoch ein Gleichanteil der Signale vor dem Ermitteln des Amplitudenquotienten zu entfernen.

Alle in der vorgenannten Figurenbeschreibung, in den Ansprüchen und in der Beschreibungseinleitung genannten Merkmale sind sowohl einzeln als auch beliebiger Kombination miteinander einsetzbar. Die Offenbarung der Erfindung ist somit nicht auf die beschriebenen bzw. beanspruchten Merkmalskombinationen beschränkt. Vielmehr sind alle Merkmalskombinationen als offenbart zu betrachten.

**Patentansprüche**

1.  Verfahren zum Ermitteln wenigstens einer Frequenz ($f_0$) eines Signals ($s[n]$),
    **gekennzeichnet durch** folgende Schritte:

    a) Filtern des Signals ($s[n]$) mittels eines ersten frequenzabhängigen Filters ($H_j(z)$) zum Erzeugen von einem ersten gefilterten Signal ($s_j[n]$) und Filtern des Signals ($s[n]$) mittels eines vom ersten frequenzabhängigen Filter ($H_j(z)$) verschiedenen zweiten frequenzabhängigen Filters ($H_k(z)$) zum Erzeugen von einem zweiten gefilterten Signal ($s_k[n]$),
    b) Ermitteln wenigstens eines Quotienten, nämlich eines aus nur einem oder mehreren Werten bestehenden Amplitudenquotienten ($\Theta[n]$), vom ersten gefilterten Signal ($s_j[n]$) zum zweiten gefilterten Signal ($s_k[n]$) und
    c) Ermitteln der wenigstens einen Frequenz ($f_0$), bei der ein Amplitudenwert eines relativen Frequenzgangs ($H_\Theta(\omega)$), der ein Quotient von einem Amplitudenfrequenzgang ($H_j(\omega)$) des ersten frequenzabhängigen Filters ($H_j(z)$) zu einem Amplitudenfrequenzgang ($H_k(\omega)$) des zweiten frequenzabhängigen Filters ($H_k(z)$) ist, dem Amplitudenquotienten ($\Theta[n]$) entspricht.

2.  Verfahren nach Anspruch 1,
    **dadurch gekennzeichnet, dass**
    das erste frequenzabhängige Filter ($H_j(z)$) und das zweite frequenzabhängige Filter ($H_k(z)$), nachfolgend als Filterpaar ($H^F(z)$) bezeichnet, vor dem Filtern des Signals ($s[n]$) aus einer Vielzahl von frequenzabhängigen Filtern, insbesondere aus einer mindestens drei Filter aufweisenden Filterbank ($H(z)$), ausgewählt werden, wobei zumindest eines der Filter des Filterpaars ($H^F(z)$) im Bereich der wenigstens einen Frequenz ($f_0$) eine positive Steigung oder eine negative Steigung in seinem Amplitudenfrequenzgang aufweist.

3.  Verfahren nach Anspruch 1 oder 2,
    **dadurch gekennzeichnet, dass**
    das Signal ($s[n]$) abgetastet wird und somit zeitdiskret und wertdiskret ist.

4.  Verfahren nach einem der vorherigen Ansprüche,
    **dadurch gekennzeichnet, dass**
    vor dem Ermitteln des wenigstens einen Amplitudenquotienten ($\Theta[n]$) ein absoluter Betrag des ersten gefilterten Signals ($s_j[n]$) und/oder ein absoluter Betrag des zweiten gefilterten Signals ($s_k[n]$) gebildet wird.

5.  Verfahren nach einem der vorherigen Ansprüche,
    **dadurch gekennzeichnet, dass**
    der relative Frequenzgang ($H_\Theta(\omega)$) ein oder mehrmals durch Bilden eines Verhältnisses vom Amplituden-Frequenzgang ($H_j(\omega)$) des ersten frequenzabhängigen Filters ($H_j(z)$) zum Amplitudenfrequenzgang ($H_k(\omega)$) des zweiten frequenzabhängigen Filters ($H_k(z)$) erzeugt wird.

6.  Verfahren nach einem der vorherigen Ansprüche,
    **dadurch gekennzeichnet, dass**
    ein Gleichanteil des Signals ($s[n]$) vor dem Filtern des Signals ($s[n]$) entfernt wird oder durch das Filtern des Signals ($s[n]$) entfernt wird, indem der Amplitudenfrequenzgang ($H_j(\omega)$) des ersten frequenzabhängigen Filters ($H_j(z)$) und/oder der Amplitudenfrequenzgang ($H_k(\omega)$) des zweiten frequenzabhängigen Filters ($H_k(z)$) derart ausgebildet ist, um Gleichanteile zu unterdrücken.

7.  Verfahren nach einem der vorherigen Ansprüche,
    **dadurch gekennzeichnet, dass**,
    falls der ein oder mehrere Werte umfassende Amplitudenquotient ($\Theta[n]$) mehr als nur einen Wert umfasst, die Anzahl der Werte auf bis zu nur einem Wert ($\Theta_\Delta[n]$) reduziert oder zusammengefasst wird, indem Werte mittels eines stochastischen Analyseverfahrens, insbesondere mittels eines unteren, mittleren und/oder oberen Quartil errechnendem Verfahren, bestimmt werden.

8.  Verfahren nach einem der vorherigen Ansprüche,
    **dadurch gekennzeichnet, dass**
    die wenigstens eine Frequenz ($f_0$) aus dem relativen Frequenzgang ($H_\Theta(\omega)$) und dem ein oder mehrere Werte umfassenden Amplitudenquotienten ($\Theta[n]$) mittels der Gleichung

    $$0 = \Theta[n] - H_\Theta(\omega),$$

    durch numerisches, analytisches oder näherungsweises Auflösen dieser Gleichung nach der wenigstens einen Frequenz ($f_0$) ermittelt wird, wobei $\omega = 2\pi \cdot f_0$ einer Kreisfrequenz, $\Theta[n]$ dem bzw. den Amplitudenquotienten und $H_\Theta(\omega)$ dem relativen Frequenzgang entspricht.

9.  Verfahren nach einem der Ansprüche 1 bis 7,
    **dadurch gekennzeichnet, dass**
    die wenigstens eine Frequenz ($f_0$) aus dem relativen Frequenzgang ($H_\Theta(\omega)$) und aus dem nur einen Wert umfassenden Amplitudenquotienten ($\Theta[n]$) mittels Einsetzen dieses Amplitudenquotienten ($\Theta[n]$) in eine Umkehrfunktion des relativen Frequenzgangs ($H_\Theta(\omega)$) mittels der Gleichung

    $$1/(2\pi) \cdot H_\Theta^{-1}(\Theta[n]) = f_0$$

ermittelt wird, wobei $H_\Theta^{-1}(\Theta[n])$ die Umkehrfunktion des relativen Frequenzgangs ($H_\Theta(\omega)$), die ein Argument $\Theta[n]$ aufweist, das dem nur einen Wert aufweisenden Amplitudenquotienten ($\Theta[n]$) entspricht, $\pi$ die Kreiszahl und $f_0$ die zu ermittelnde Frequenz ist.

10. Verfahren nach einem der Ansprüche 2 bis 9,
**dadurch gekennzeichnet, dass**
das Verfahren mehrfach mit demselben Signal ($s[n]$), jedoch mit voneinander verschiedenen Filterpaaren ($H^F(z)[m]$) ausgeführt wird und daher mehrere Frequenzen ($f_0[m]$) ermittelt werden, die mittels eines stochastischen Analyseverfahrens, insbesondere mittels eines Mittelwert oder Schnittmengen errechnendem Verfahrens, zu nur einer Frequenz reduziert werden, die die wenigstens eine zu ermittelnden Frequenz ($f_0$) ist.

11. Verfahren nach Anspruch 10,
**dadurch gekennzeichnet, dass**
die Filter der voneinander verschiedenen Filterpaare ($H^F(z)[m]$) iterativ, nach einer erwarteten Frequenz oder unter Berücksichtigung von Informationen vorheriger und/oder parallel ausgeführter Verfahren bestimmt werden.

12. Vorrichtung zur Ermittlung wenigstens einer Frequenz ($f_0$) eines Signals ($s[n]$), insbesondere zur Durchführung eines Verfahrens nach einem der Ansprüche 1 bis 11,
**gekennzeichnet durch**

 a) ein Filtermodul (40), das mindestens einen ersten frequenzabhängigen Filter ($H_j(z)$) und einen vom ersten frequenzabhängigen Filter ($H_j(z)$) verschiedenen zweiten frequenzabhängigen Filter ($H_k(z)$) aufweist, die derart ausgebildet sind, um das Signal ($s[n]$) zu filtern, damit ein erstes gefiltertes Signal ($s_j[n]$) und ein zweites gefiltertes Signal ($s_k[n]$) erzeugbar sind,
 b) ein Relationsmodul (42), das derart ausgebildet ist, um wenigstens einen Quotienten, nämlich einen aus nur einem oder mehreren Werten bestehenden Amplitudenquotienten ($\Theta[n]$), vom ersten gefilterten Signal ($s_j[n]$) zum zweiten gefilterten Signal ($s_k[n]$) zu ermitteln und
 c) ein Gleichungsmodul (44), das derart ausgebildet ist, um die wenigstens eine Frequenz ($f_0$) zu ermitteln, bei der ein Amplitudenwert eines relativen Frequenzgangs ($H_\Theta(\omega)$), der ein Quotient von einem Amplitudenfrequenzgang ($H_j(\omega)$) des ersten frequenzabhängigen Filters ($H_j(z)$) zu einem Amplitudenfrequenzgang ($H_k(\omega)$) des zweiten frequenzabhängigen Filters ($H_k(z)$) ist, dem einen oder mehrere Werte umfassenden Amplitudenquotienten ($\Theta[n]$) entspricht.

13. Vorrichtung nach Anspruch 12,
**dadurch gekennzeichnet, dass**
das Filtermodul (40) als Filterbank ($H(z)$) ausgebildet ist, die eine Filterstruktur mit mindestens drei frequenzabhängigen Filtern, insbesondere mindestens einen Hochpassfilter und mindestens einen Tiefpassfilter, aufweist.

14. Vorrichtung nach einem der Ansprüche 12 oder 13,
**dadurch gekennzeichnet, dass**
das Filtermodul (40) ein Filterstufenauswahlmodul (50) aufweist, das derart ausgebildet ist, um aus mindestens drei Filtern des Filtermoduls (40) nur zwei Filter, nämlich das erste frequenzabhängige Filter ($H_j(z)$) und das zweite frequenzabhängige Filter ($H_k(z)$), auszuwählen und somit das erste gefilterte Signal ($s_j[n]$) und das zweite gefilterte Signal ($s_k[n]$) für das Relationsmodul (42) zu bestimmen.

15. Computerprogramm, welches Computerprogrammcodemittel aufweist, die für die Ausführung des Verfahrens nach einem der Ansprüche 1 bis 11 geeignet sind, wenn das Programm auf einem Computer ausgeführt wird.

Fig. 1

Fig. 2

_Fig. 3_

_Fig. 4_

Fig. 5A

Fig. 5B

Fig. 6A

Fig. 6B

Fig. 7A

Fig. 7B

**IN DER BESCHREIBUNG AUFGEFÜHRTE DOKUMENTE**

**In der Beschreibung aufgeführte Patentdokumente**

- DE 3504890 A1
- DE 19608331 C2

- WO 2004005945 A1